# EUROPÄISCHE PATENTSCHRIFT

(11) **EP 3 630 303 B1**
(45) Veröffentlichungstag und Bekanntmachung des Hinweises auf die Patenterteilung: **27.03.2024**
(21) Anmeldenummer: 18725537.7
(22) Anmeldetag: 18.05.2018
(51) Int. Cl.: H05K 5/02, H02B 1/28, A62C 4/00

(54) **GEHÄUSE MIT EINGEGOSSENER DRUCKENTLASTUNG**
HOUSING HAVING CAST PRESSURE RELIEF MEANS
BOÎTIER POURVU D'UN ÉLÉMENT DÉPRESSURISATION INCORPORÉ PAR MOULAGE

(30) Priorität: 01.06.2017 DE 102017112147
(43) Veröffentlichungstag der Anmeldung: 08.04.2020
(73) Patentinhaber: R. Stahl Schaltgeräte GmbH, 74638 Waldenburg (DE)
(72) Erfinder: ARNHOLD, Thorsten, 74629 Pfedelbach (DE); HERMANOWSKI, Clife, 74743 Seckach (DE)
(74) Vertreter: Rüger Abel Patentanwälte PartGmbB
(86) Internationale Anmeldenummer: PCT/EP2018/063152
(87) Internationale Veröffentlichungsnummer: WO 2018/219696

(56) Entgegenhaltungen:
- EP-A2- 2 842 609
- AT-B- 414 121
- US-A1- 2013 206 759

## Beschreibung

Gegenstand der Erfindung sind Gussgehäuse, insbesondere Metallgussgehäuse mit wenigstens einem Druckentlastungskörper.

Im Bereich des Explosionsschutzes sind explosionsgeschützte Gehäuse mit Druckentlastungsvorrichtungen bekannt.

Dazu beschreibt die DE 10 2013 109 259 A1 ein Gehäuse mit einem porösen Körper, der in ein Aufnahmeteil eingesetzt ist. Als Aufnahmeteil kann eine Gehäusewand oder ein Gehäusewandabschnitt des explosionsgeschützten Gehäuses dienen. Die Randzone des porösen Körpers ist form- und/oder stoffschlüssig mit dem Aufnahmeteil verbunden. Der Formschluss ergibt sich durch Eindringen von Gussmaterial in Poren des aus unregelmäßig angeordneten, miteinander verschlungenen Metallfasern bestehenden porösen Körpers. Das zu tiefe Eindringen von Gusswerkstoff in den porösen Körper wird durch eine Barriere verhindert, die in der Randzone des porösen Körpers angeordnet ist. Der Gießvorgang selbst ist ein Druckgussspritzguss oder Spritzpressvorgang.

Aus der DE 10 2013 109 260 A1 ist es darüber hinaus bekannt, ganze Gehäuseteile, beispielsweise Gehäusewände, Gehäusedecken oder Gehäuseböden aus einem porösen Material auszubilden, das durch unregelmäßig miteinander verschlungene Fasern gebildet ist.

Aus der EP 2 842 609 A2 und der US 2013/0206759 A1 ist eine Druckentlastungsvorrichtung in Gestalt eines Einsatzteils bekannt, das einen zentralen Durchgang aufweist. In dem zentralen Durchgang sitzt ein Druckentlastungskörper, der zwischen einem ein Ringschulter bildenden Anschlag und einer Spannmutter gehalten ist.

Weiter offenbart die AT 414 121 B einen Sicherheitscontainer mit einem aus mehreren Wandeilen bestehenden Gehäuse. Die Wandteile überlappen einander an den Stoßstellen Z-förmig, wobei in dem Überlappungsbereich ein Freiraum ausgebildet ist. Der Freiraum ist durch gebündelt angeordnetes Streckmaterial ausgefüllt, das gasdurchlässig, dabei aber flammensperrend ausgebildet ist.

Größere Gehäuse der Bauart "druckfeste Kapselung" können als Aluminium-Gussgehäuse ausgebildet sein. Solche Gehäuse werden für ein weites Einsatzspektrum vorgesehen, so dass sich hohe Anforderungen zum Beispiel auch an den Einsatztemperaturbereich ergeben. Am Gehäuse vorhandene Spalte dürfen bei keiner der im Einsatz vorkommenden Temperaturen einen Flammendurchschlag zulassen. Es muss sichergestellt bleiben, dass Flammen, Funken oder dergleichen, nicht aus dem Innenraum des Gehäuses nach außen in eine explosionsgefährdete Umgebung gelangen können. Das Gehäuse sowie die Druckentlastungsvorrichtung muss daher einem Explosionsdruck standhalten können.

Davon ausgehend ist es Aufgabe der Erfindung, ein Gehäuse der Bauart "druckfeste Kapselung" bereitzustellen, das für einen weiten Einsatztemperaturbereich geeignet ist.

Diese Aufgabe wird mit einem Gehäuse nach Anspruch 1 gelöst. Bevorzugte Ausführungsformen sind in den Unteransprüchen angegeben.

Das erfindungsgemäße Gehäuse besteht aus zumindest zwei Gehäuseteilen, von denen mindestens eines ein Gussteil ist, das eine Druckausgleichsöffnung aufweist. In dieser Druckausgleichsöffnung ist ein Druckentlastungskörper angeordnet, der zwei voneinander weg weisende Flachseiten aufweist. Eine der Flachseiten steht mit der Umgebung in Berührung während die andere Flachseite dem Innenraum des Gehäuses zugewandt ist. Erfindungsgemäß ist das Gehäuseteil so ausgebildet, dass es den Druckentlastungskörper an seinen beiden Flachseiten übergreift und somit mit diesem einen makroskopischen Formschluss aufweist. Entsprechend erstreckt sich der den Druckentlastungskörper übergreifende Abschnitt des Gehäuseteils entlang des gesamten Randes des Druckentlastungskörpers vorzugsweise ununterbrochen. Zusätzlich ist vorzugsweise ein mikroskopischer Formschluss vorhanden, indem sich bei der Gehäuseherstellung flüssiges Gehäusematerial an die raue oder porige Oberfläche des Druckausgleichskörpers anschmiegt und auch etwas in Poren eindringt. Dadurch wird eine Randabdichtung des Druckentlastungkörpers sichergestellt.

Mit diesem Konzept lassen sich großflächige Druckentlastungskörper in Gehäuseteilen großvolumiger Gehäuse anordnen, die vorzugsweise einige Liter Innenvolumen, auch einige zehn Liter Innenvolumen aufweisen können. Das erfindungsgemäße Konzept erbringt eine sichere Befestigung des Druckentlastungskörpers in dem Gehäuseteil und gestattet eine Reduktion der Dicke der Gehäusewand und eine Festlegung der Wandstärke derselben, unabhängig von der Dicke des Druckentlastungskörpers, was zu Material- und Gewichtseinsparung genutzt werden kann. Außerdem wird die mechanisch sichere und zugleich flammendurchschlagsichere Befestigung auch sehr großflächiger Druckentlastungskörper in Gehäusen ermöglicht, die in einem sehr weiten Temperaturbereich einsetzbar sind. Dies gilt auch dann, wenn das Gussteil aus einem Material mit sehr hohem Temperaturausdehnungskoeffizienten, wie zum Beispiel Aluminium, hergestellt ist und wenn der Druckentlastungskörper einen davon deutlich verschiedenen Wärmeausdehnungskoeffizienten aufweist, weil er z.B. aus Edelstahl besteht. Beispielsweise kann der Druckentlastungskörper aus mehreren Edelstahlgewebelagen bestehen, die durch einen Sinterprozess miteinander verbunden worden sind. Sie bilden damit einen gasdurchlässigen, starren Körper, der einen anderen Temperaturgang aufweist als das Aluminium-Gussteil.

Das z.B. aus Aluminium bestehende Gussteil kann insbesondere ein im Schwerkraftguss, insbesondere im Sandguss, hergestelltes Gussteil sein. Es entsteht dabei eine formschlüssige Verbindung zwischen dem Gussteil und dem Druckentlastungskörper.

Vorzugsweise sind die Materialien für das Gehäuseteil und den Druckentlastungskörper so ausgewählt, dass die Schmelztemperatur des Materials des Gehäuseteils niedriger ist, als die Schmelztemperatur des Druckentlastungskörpers, wobei das flüssige Material des Gehäuseteils keine oder nur geringe Benetzungsneigung zu dem Material, insbesondere der Oberfläche, des Druckentlastungskörpers hat. Unter "Oberfläche" wird dabei sowohl die außen sichtbare Oberfläche als auch die Drahtoberfläche in Körperinneren, d.h. die Oberfläche der Poren verstanden. Dazu wird vorzugsweise davon abgesehen, insbesondere an den Flachseiten des Druckentlastungskörpers vorhandene Oxidschichten oder andere Passivierungsschichten abzutragen. Vorzugsweise ist der Kontaktwinkel zwischen dem Gehäusematerial und dem Material des Druckentlastungskörpers mindestens 90° (=n/2), vorzugsweise grö-βer als 150°. Vorzugsweise unterbleibt eine dadurch die Benetzung der Oberfläche des Druckentlastungskörpers mit dem flüssigen Wandmaterial (z.B. Aluminium) während des Gießvorgangs, so dass eine Porenfüllung durch Kapillarwirkung unterbleibt. Auch unterbleibt zumindest an den Flachseiten oder auch insgesamt zumindest weitgehend die Ausbildung einer Lötverbindung, d.h. einer Legierungszone zwischen flüssigen Wandmaterial (z.B. Aluminium) und dem Material des Druckentlastungskörpers. Dadurch ist die Verbindung zwischen dem Druckentlastungskörper und dem Gussteil sowohl mikroskopisch als auch makroskopisch vorzugsweise rein formschlüssig. Mikrobewegungen infolge unterschiedlicher Temperaturausdehnungen führen nicht zum Materialbruch und der Ausbildung von Rissanfängen. Dies stellt die mechanische Integrität des Gehäuses, insbesondere der Verbindung zwischen dem Gehäuse und dem Druckentlastungskörper sicher. Dynamischen Lasten, insbesondere bei Explosion im Gehäuseinneren auftretende Drucklasten, ist das Gehäuse somit unabhängig von der Gehäusetemperatur gewachsen. Auch kann die auch lediglich temporäre Entstehung und Freigabe von Spalten, die einen Flammendurchschlag entlang des Randes des Druckentlastungskörpers gestatten würden, sicher ausgeschlossen werden. Die mikroskopische und makroskopische Verzahnung zwischen dem Druckentlastungskörper und dem Gussteil, kann mikroskopische Bewegungen aufgrund unterschiedlicher Wärmeausdehnungen des Gehäuseteils und des porösen Körpers zulassen, ohne den Flammendurchschlagschutz zu beeinträchtigen oder zu Gehäuserissen zu führen.

Es ist aber auch möglich, eine stellenweise Benetzung des Druckentlastungskörpers mit flüssigem Wandmaterial z.B. an der peripheren Umfangsfläche des Druckentlastungskörpers zuzulassen. Diese kann als Schnittfläche metallisch blank sein. Eine hier vorhandene Lötverbindung zwischen dem Gehäusematerial und dem Druckentlastungskörper kann unschädlich sein.

Vorzugsweise weist das Gehäuse zwei Gehäuseteile auf, die an einer Trennfläche aneinander stoßen, die parallel zu den Flachseiten des Druckentlastungskörpers orientiert ist. Dies gestattet die Herstellung des Gehäuses bzw. des Gehäuseteils in einer Gussform für den Schwerkraftguss, wobei die Gussform lediglich eine äußere Form und einen Kern, nicht aber bewegliche Schieber oder dergleichen aufweisen muss.

Der Druckentlastungskörper ist vorzugsweise ein starrer Körper, der vorzugsweise aus mehreren miteinander durch Sinterung verbundenen Drahtgewebelagen besteht. Die einzelnen Drahtgewebelagen weisen vorzugsweise Kettdrähte und Schussdrähte auf, die miteinander in Leinwandbindung stehen. Die einzelnen Lagen sind gegeneinander versetzt und/oder verdreht, um labyrinthartige Gasdurchgänge festzulegen. Durch Sinterung sind die Kett- und/oder Schussdrähte der einzelnen Lagen miteinander verbunden, so dass der Sinterkörper weitgehend starr ist. Das sich ergebende Elastizitätsmodul und/oder das Biegemodul des Druckentlastungskörpers kann sich von dem Elastizitätsmodul und/oder dem Biegemodul der Gehäusewand unterscheiden.

Weitere Einzelheiten vorteilhafter Ausführungsformen der Erfindung sind Gegenstand von Unteransprüchen, der Zeichnung oder der Beschreibung. Es zeigen:
Figur 1 ein erfindungsgemäßes Gehäuses, in schematisierter Perspektivdarstellung,
Figur 2 das erfindungsgemäße Gehäuse nach Figur 1, im vereinfachten Längsschnitt,
Figur 3 eine ausschnittsweise vergrößerte Darstellung des Gehäuses nach Figur 2 zur Veranschaulichung der Schnittstelle zwischen dem Druckentlastungskörper, dem Gehäuse
Figur 4 die Schnittstelle zwischen dem Druckentlastungkörper und dem Gehäuse, in vergrößerter Schnittdarstellung, und
Figur 5 einen weiter vergrößerten Ausschnitt aus Figur 4.

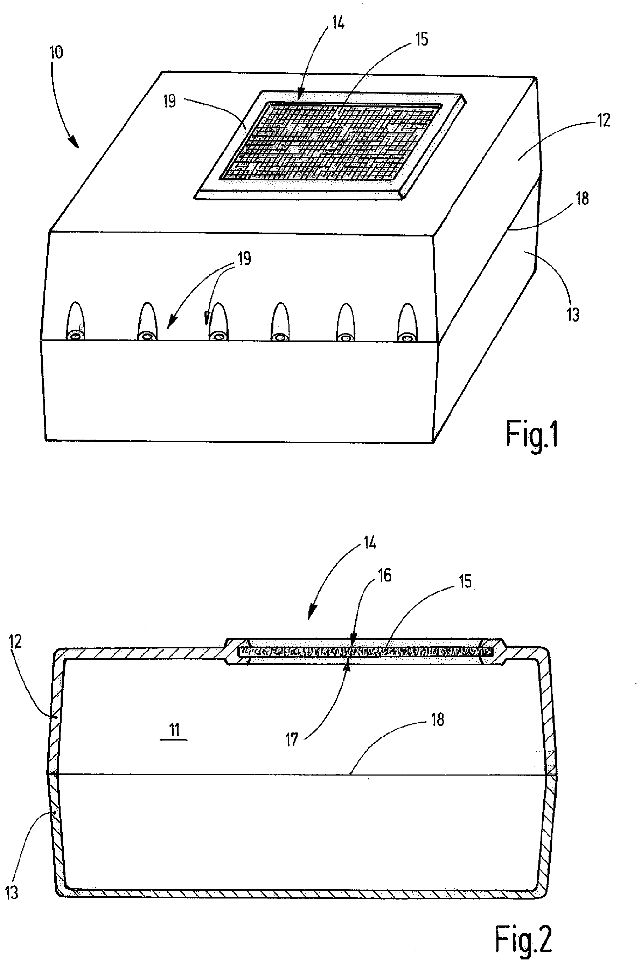

In Figur 1 ist ein Gehäuse 10 veranschaulicht, das als explosionsgeschütztes Gehäuse nach der Bauart "druckfeste Kapselung" (ex-d) ausgebildet ist. Es umschließt einen aus Figur 2 ersichtlichen Innenraum 11, in dem nicht weiter veranschaulichte elektrische und/oder elektronische Bauteile oder Komponenten angeordnet sein können, die Zündquellen für ein außerhalb des Gehäuses vorhandenes explosionsfähiges Gasgemisch darstellen können.

Zu dem Gehäuse gehören wenigstens zwei Gehäuseteile 12, 13, die den Innenraum 11 umschließen. In wenigstens einem der beiden Gehäuseteil 12, 13 ist eine Druckausgleichsöffnung 14 ausgebildet, in der ein Druckentlastungskörper 15 angeordnet ist. Dieser ist vorzugsweise ein plattenförmiger, ebener Sinterkörper mit einer ersten nach außen weisenden Flachseite 16 und einer zweiten dem Innenraum 11 zugewandten Flachseite 17. Beide Flachseiten 16, 17 nehmen vorzugsweise jeweils die gesamte Fläche der Druckausgleichsöffnung 14 ein und weisen auf ganzer Fläche Öffnungen von flammendurchschlagsicheren Kanälen auf, die sich durch den Druckentlastungskörper 15 erstrecken. Vorzugsweise wird der Druckentlastungskörper 15 durch miteinander verschweißte bzw. durch Sintern verbundene ebene Lagen aus Metallgewebe gebildet. Das Metallgewebe ist vorzugsweise aus Edelstahldrähten gefertigt.

Das Gehäuseteil 12 kann, wie in den Figuren 1 und 2 dargestellt, lediglich den einen Druckentlastungskörper 15 oder auch mehrere solcher Druckentlastungskörper aufweisen. Vorzugsweise ist der Druckentlastungskörper 15 so angeordnet, dass seine Flachseiten 16, 17 parallel zu einer Trennebene 18 angeordnet sind, an der die Gehäuseteile 12, 13 aneinander anstoßen und an der sie miteinander verbunden sind. Dazu können alle geeigneten Verbindungstechniken dienen. In Figur 1 sind dazu Schraubverbindungen 19 angedeutet. Alternativ oder zusätzlich können die Gehäusehälften 12, 13 miteinander verklebt, verschweißt oder verklemmt sein.

Das Gehäuseteil 13 kann prinzipiell ähnlich oder gleich wie das Gehäuseteil 12 ausgebildet sein. Insbesondere kann es einen oder mehrere Druckentlastungskörper enthalten, die ebenso mit dem Gehäuseteil 13 verbunden sind, wie der Druckentlastungskörper 15 mit dem Gehäuseteil 12 verbunden ist.

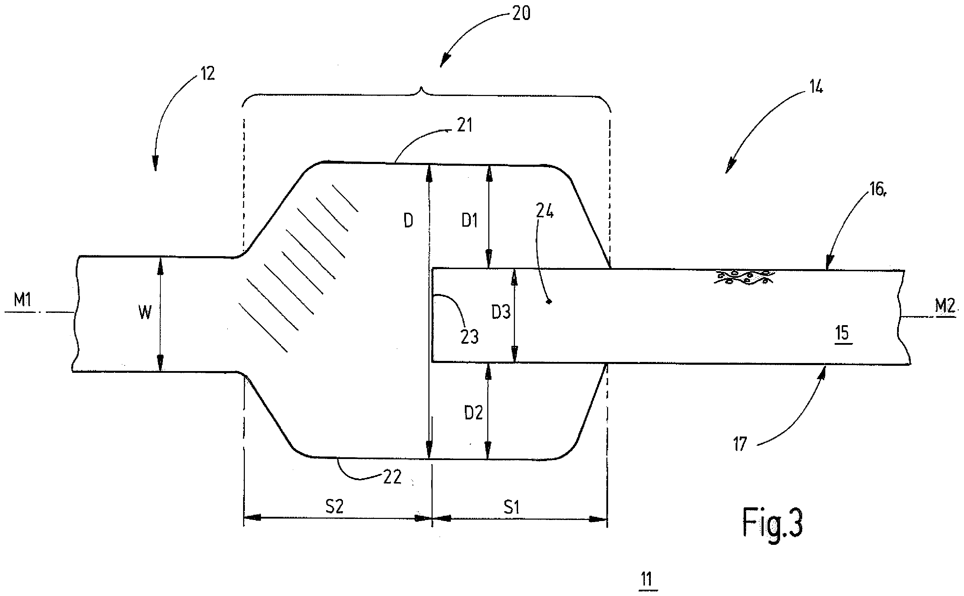

Die erfindungsgemäße Verbindung zwischen dem Druckentlastungskörper 15 und dem Gehäuseteil 12 ist in Figur 3 gesondert veranschaulicht:

Das Gehäuseteil 12 ist ein Kunststoff- oder Metallgussteil, vorzugsweise ein Aluminiumgussteil, das im Schwerkraftgussverfahren, zum Beispiel im Sandgussverfahren hergestellt worden ist. Es weist eine Wandstärke W auf, die vorzugsweise größer als 7 mm ist und umschließt einen Innenraum von mindestens einem Liter Größe. Die Gehäusewand kann eine gleichmäßige Dicke aufweisen oder mit Rippen oder sonstigen aussteifenden Vorsprüngen versehen sein. Die Wandstärke W ist dabei außerhalb eines verdickten, die Druckausgleichsöffnung 14 umgebenden Bereichs 20 zu messen. Dieser verdickte Bereich 20 weist eine äußere, vorzugsweise wenigstens abschnittsweise ebene Fläche 21 und eine dem Innenraum 11 zugewandte, vorzugsweise ebenfalls wenigstens abschnittsweise ebene Fläche 22 auf, zwischen denen die Dicke D des verdickten Bereichs 20 zu messen ist. Insbesondere ist die Dicke D, wie in Figur 3 dargestellt, in unmittelbarer Nachbarschaft zu einer Umfangsfläche 23 des Druckentlastungskörpers 15 zu messen. Die Umfangsfläche 23 verbindet die äußere Flachseite 16 mit der inneren Flachseite 17. Sie ist beispielsweise durch eine Schnittfläche gebildet, an der der Druckentlastungskörper 15 aus einem größeren Materialverbund herausgetrennt worden ist. die Umfangsfläche 23 kann wie die Flachseite 16 und die Flachseite 17 offene Poren aufweisen.

Der Druckentlastungskörper 15 ist mit einer Randzone 24 in den verdickten Bereich 20 eingebettet und in diesem gehalten. Dabei liegt eine mittig zwischen den Flachseiten der Gehäusewand liegende Mittelebene M1 zum Beispiel auf gleicher Höhe wie eine Mittelebene M2, die mittig zwischen den Flachseiten 16, 17 des Druckentlastungskörpers 15 angenommen ist. In diesem Fall bilden die Mittelebenen M1, M2 eine gemeinsame Ebene. Es ist jedoch auch möglich, die beiden Mittelebenen M1, M2 gegeneinander zu versetzen, so dass der verdickte Bereich 20 bezüglich der Mittelebene M1 asymmetrisch ausgebildet und/oder der Druckentlastungskörper 15 bezüglich der Gehäusewand außermittig angeordnet ist. Damit kann der bevorzugten Richtung der Druckbelastung Rechnung getragen werden, beispielsweise indem der verdickte Bereich 20 an seiner Außenseite 21 eine Dicke D1 aufweist, die größer ist als die Dicke D2 des verdickten Bereichs 20 an seiner Innenseite, jeweils gemessen an der Randzone 24. Bei der in Figur 3 veranschaulichten Ausführungsform sind die Dicken D1 und D2 jedoch gleich.

Der verdickte Bereich 20 erstreckt sich über die Randzone 24 des Druckentlastungskörpers 15, über eine Strecke S1, die vorzugsweise größer als wenigstens 5 mm ist. Diese Strecke S1 definiert die Breite der in den verdickten Bereich 20 eingebetteten Randzone 24. Von der Umfangsfläche 23 ausgehend bis zum unverdickten Bereich der Gehäusewand erstreckt sich der verdickte Bereich 20 über eine Strecke S2. Diese ist vorzugsweise ebenso groß wie die Strecke S1 oder auch kürzer als diese.

Die Dicke D1 und/oder D2 des jeweiligen verdickten Bereichs beträgt vorzugsweise wenigstens 4 mm. Die zwischen den beiden Flachseiten 16, 17 zu messende Dicke D3 des Druckentlastungskörpers 15 kann vorzugsweise im Bereich von 2 bis 10 mm liegen.

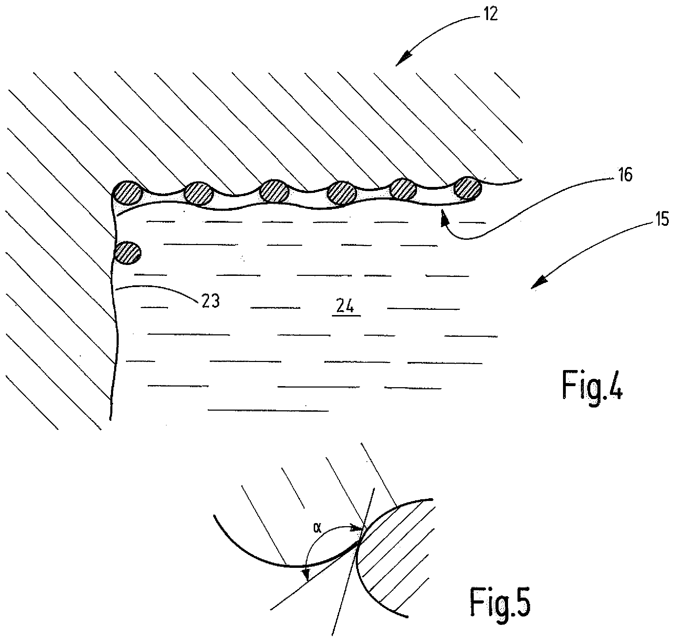

Figur 4 zeigt die Verbindung zwischen Der Randzone 24 und dem Gehäusematerial in ausschnittsweiser vereinfachter Darstellung. Wie ersichtlich schmiegt sich das Gehäusematerial sowohl an der Flachseite 16 (und entsprechend 17), als auch an der Umfangsfläche 23 an den Druckentlastungskörper 15 an, ohne tief in den Druckentlastungskörper einzudringen. Jedoch bildet sich eine Mikroverzahnung zwischen dem Gehäusematerial und den Drähten des Druckentlastungskörpers 15, d.h. ein Mikroformschluss.

Die Schmelztemperatur des Materials des Gehäuseteils 12 ist niedriger als die Schmelztemperatur des Druckentlastungskörpers 15. Das flüssige Material des Gehäuseteils 12 hat keine oder nur eine geringe Benetzungsneigung zu dem Material des Druckentlastungskörpers 15 hat. Z.B wird dies durch die Materialpaarung Edelstahl (für den Druckentlastungskörper 15) und Aluminiumlegierung (für das Gehäuseteil 12) erreicht. Der in Figur 5 veranschaulichte Kontaktwinkel α ist vorzugsweise größer als 90°, weiter vorzugsweise größer als 120°, 150°, oder 160°. Es unterbleibt weitgehend die Ausbildung von Legierungszonen und Lötverbindungen zwischen dem Gehäuseteil 12 und dem Druckentlastungskörper. Deswegen sind mikroskopische Relativbewegungen ohne Entstehung von zu großen lokalen Scherspannungen im Gefüge des Gehäuseteils 12 an der Berührungsfläche zwischen dem Gehäuseteil 12 und dem Druckentlastungskörper 15 möglich. Es unterbleibt die Ausbildung von Mikrorissen im Gefüge des Gehäuseteils, die sonst zu Rissanfängen führen und die mechanische Belastbarkeit des Gehäuses, auch die Druckimpulsbelastbarkeit, auf Dauer kompromittieren könnten.

Mit den beschriebenen Gegebenheiten ist das Gehäuseteil 12 in einem weiten Temperaturbereich von zum Beispiel -60°C bis +80°C stabil und sicher zu verwenden. Eine in dem Innenraum 11 ausgelöste Explosion bleibt auf den Innenraum 11 beschränkt. Unabhängig davon, ob an der Verbindungsstelle zwischen dem Druckentlastungsköper 15 und dem verdickten Bereich 20 des Gehäuseteils 12 temperaturbedingt Zug- oder Druckspannung herrschen, führen entsprechende stoßweise Druckbelastungen nicht zum Öffnen von Fugen oder Spalten, durch die Flammen oder glühende Partikel hindurchtreten könnten.

Bei der Herstellung des Gehäuseteils 12 wird der Druckentlastungskörper 15 in die Gravur einer Gießform eingelegt und dann der Formkern auf dem Druckentlastungskörper 15 platziert. Beim nachfolgenden Einfüllen von flüssigem Gehäusematerial, insbesondere Metall, beispielsweise Aluminium oder einer Aluminiumlegierung, füllt dieses den zwischen dem Formenkern und der Gießform vorhandene Spalt und formt somit das Gehäuseteil 12 einschließlich des verdickten Bereichs 20. In diesem umfließt das flüssige Gehäusematerial die Randzone 24 des Druckentlastungskörpers 15, wobei es oberflächlich in die Öffnungen des Druckentlastungskörpers 15 eindringt. Dadurch entsteht eine Mikroverzahnung. Besteht der Druckentlastungskörper 15 aus Edelstahldraht und ist das Material des Gehäuseteils 12 Aluminium oder eine Aluminiumlegierung, kommt es allenfalls stellenweise typischerweise aber gar nicht zu einer Benetzung zwischen dem Druckentlastungskörper 15 und dem flüssigen Metall des Gehäuseteils 12. Dadurch verhindert die Oberflächenspannung des flüssigen Formmaterials ein tieferes Eindringen des Gehäusewandmaterials in den Druckentlastungskörper 15. Damit wird auch bei großen Gehäusen, die eine erhebliche Abkühlzeit benötigen, verhindert, dass der Druckentlastungskörper 15 durch Kapillareffekte mit flüssigem Metall gefüllt und somit verengt oder verschlossen wird. Vielmehr bleiben die Poren des Druckentlastungskörpers 15 auch in der Randzone 24 frei von Aluminium oder sonstigem Gehäusematerial.

Das erfindungsgemäße Gehäuse 10 weist mindestens einen Druckentlastungskörper 15 auf, der in einer Druckausgleichsöffnung 14 eines der Gehäuseteile 12, 13 angeordnet ist. Zur Befestigung des Druckausgleichskörpers 15 in bzw. an dem Gehäuseteil 12 ist ein verdickter Bereich 20 vorgesehen, der die Randzone des Druckentlastungskörpers 15 entlang der gesamten Umfangsfläche 23 des Druckentlastungskörpers 15 an beiden Flachseiten 16, 17 des Druckentlastungskörpers 15 übergreift. Die sich dabei ergebende Einbettungstiefe S1, die parallel zu den Flachseiten 16,17 zu messen ist, ist dabei vorzugsweise größer als die Dicke D1, D2 des die Randzone 24 übergreifenden Teils des verdickten Bereichs 20. Der Druckentlastungskörper 15 besteht aus gesintertem Drahtgewebe. Durch das Bündel dieser Maßnahmen wird eine sowohl mikroskopische als auch makroskopische formschlüssige Verbindung zwischen dem Druckentlastungskörper 15 und dem Gehäuseteil 12 erreicht. Diese Verbindung ist in einem weiten Temperaturbereich langzeitstabil und druckfest.

### Bezugszeichen:

| | |
|---|---|
| 10 | Gehäuse |
| 11 | Innenraum |
| 12, 13 | Gehäuseteile |
| 14 | Druckausgleichsöffnung |
| 15 | Druckentlastungskörper |
| 16 | äußere Flachseite des Druckentlastungskörpers 15 |
| 17 | innere Flachseite des Druckentlastungskörpers 15 |
| 18 | Trennebene |
| W | Wandstärke des Gehäuseteils 12 |
| 19 | Verschraubungen |
| 20 | verdickter Bereich um die Druckausgleichsöffnung 14 herum |
| 21 | äußere Fläche des verdickten Bereichs 20 |
| 22 | innere Fläche des verdickten Bereichs 20 |
| D | Dicke des verdickten Bereichs 20 |
| 23 | Umfangsfläche des Druckentlastungskörpers 15 |
| M1 | Mittelebene der Gehäusewand |
| M2 | Mittelebene des Druckentlastungskörpers 15 |
| 24 | Randzone des Druckentlastungskörpers 15 |
| D1, D2 | Dicke des verdickten Bereichs 20 |
| S1 | Strecke bzw. Tiefe der Einbettung des Druckentlastungskörpers in das Gehäuseteil 12 |
| S2 | Strecke von der Umfangsfläche 23 zu der unverdickten Gehäusewand |

## Patentansprüche

1. Explosionsgeschütztes Gehäuse (10),
mit wenigstens zwei Gehäuseteilen (12, 13), die in zusammengefügtem Zustand einen Innenraum (11) umgrenzen, in dem elektrische Komponenten unterbringbar sind, die Zündquellen bilden können,
wobei wenigstens eines der Gehäuseteile (12, 13) ein Gussteil ist, das eine Druckausgleichsöffnung (14) aufweist, mit wenigstens einem Druckentlastungskörper (15), der zwei voneinander weg weisende Flachseiten (16, 17) aufweist und mit dem Gussteil verbunden ist,
**dadurch gekennzeichnet,**
**dass** das Gussteil den Druckentlastungskörper (15) an seinen beiden Flachseiten (16, 17) übergreifend ausgebildet ist.

2. Gehäuse nach Anspruch 1, **dadurch gekennzeichnet, dass** die Materialien für das Gehäuseteil (12) und den Druckentlastungskörper (15) so ausgewählt sind, dass die Schmelztemperatur des Materials des Gehäuseteils (12) niedriger ist als die Schmelztemperatur des Druckentlastungskörpers (15), wobei das flüssige Material des Gehäuseteils (12) wenig oder keine Benetzungsneigung zu der Oberfläche des Druckentlastungskörpers (15) hat.

3. Gehäuse nach einem der vorstehenden Ansprüche, **dadurch gekennzeichnet, dass** das Gehäuseteil (12) ein Metall-Gussteil, vorzugsweise ein Aluminium-Gussteil ist.

4. Gehäuse nach einem der vorstehenden Ansprüche, **dadurch gekennzeichnet, dass** die beiden Gehäuseteile (12, 13) an einer Trennfläche (18) aneinander anstoßend ausgebildet sind, die parallel zu den Flachseiten (16, 17) des Druckentlastungskörpers (15) orientiert ist.

5. Gehäuse nach einem der vorstehenden Ansprüche, **dadurch gekennzeichnet, dass** der Druckentlastungskörper (15) ein Drahtnetz-Sinterkörper ist, der aus mehreren miteinander durch Sinterung verbundenen Drahtgewebelagen besteht.

6. Gehäuse nach einem der vorstehenden Ansprüche, **dadurch gekennzeichnet, dass** die Flachseiten (16, 17) des Druckentlastungskörpers (15) wenigstens abschnittweise oder vollständig eben ausgebildet sind.

7. Gehäuse nach einem der vorstehenden Ansprüche, **dadurch gekennzeichnet, dass** der Druckentlastungskörper (15) und die Druckentlastungsöffnung (14) jeweils einen rechteckigen Umriss aufweisen, wobei der Umriss des Druckentlastungskörpers (15) größer ist als der Umriss der Druckentlastungsöffnung (14).

8. Gehäuse nach einem der vorstehenden Ansprüche, **dadurch gekennzeichnet, dass** der Druckentlastungskörper (15) eine Umfangsfläche (23) aufweist, die sich zwischen den Flachseiten (16, 17) erstreckt und die als glatte Schnittfläche ausgebildet ist.

9. Gehäuse nach Anspruch 8, **dadurch gekennzeichnet, dass** das Gehäuseteil (12), an der Umfangsfläche (23) des Druckentlastungskörpers (15) gemessen, eine Dicke (D) aufweist, die größer ist, als die Dicke (D3) des Druckentlastungskörpers (15).

10. Gehäuse nach Anspruch 8, **dadurch gekennzeichnet, dass** das Gehäuseteil (12), an der Umfangsfläche (23) des Druckentlastungskörpers (15) gemessen, eine Dicke (D) aufweist, die größer ist, als die Wandstärke (W) des Gehäuseteils (12), gemessen in einem Abstand zu der Druckentlastungsöffnung (14).

## Claims

1. Explosion-proof housing (10),
with at least two housing parts (12, 13) which, when assembled, delimit an interior space (11) able to accommodate electrical components which can form ignition sources,
wherein at least one of the housing parts (12, 13) is a casting having a pressure compensation opening (14), with at least one pressure relief body (15) which has two flat sides (16, 17) facing away from one another and is connected to the casting,
**characterised in that** the casting is configured to protrude over the pressure relief body (15) on its two flat sides (16, 17).

2. Housing according to claim 1, **characterised in that** the materials for the housing part (12) and the pressure relief body (15) are selected such that the melt temperature of the material of the housing part (12) is lower than the melt temperature of the pressure relief body (15), wherein the liquid material of the housing part (12) has little or no tendency towards cross-linking to the surface of the pressure relief body (15).

3. Housing according to any of the preceding claims, **characterised in that** the housing part (12) is a metal casting, preferably an aluminium casting.

4. Housing according to any of the preceding claims, **characterised in that** the two housing parts (12, 13) are formed abutting against one another at a separating face (18) which is oriented parallel to the flat sides (16, 17) of the pressure relief body (15).

5. Housing according to any of the preceding claims, **characterised in that** the pressure relief body (15) is a sintered wire mesh body which consists of multiple woven wire layers connected together by sintering.

6. Housing according to any of the preceding claims, **characterised in that** the flat sides (16, 17) of the pressure relief body (15) are formed at least in portions or completely flat.

7. Housing according to any of the preceding claims, **characterised in that** the pressure relief body (15) and the pressure relief opening (14) each have a rectangular periphery, wherein the periphery of the pressure relief body (15) is larger than the periphery of the pressure relief opening (14).

8. Housing according to any of the preceding claims, **characterised in that** the pressure relief body (15) has a peripheral face (23) which extends between the flat sides (16, 17) and is configured as a smooth interface.

9. Housing according to claim 8, **characterised in that** the housing part (12), measured at the peripheral face (23) of the pressure relief body (15), has a thickness (D) which is greater than the thickness (D3) of the pressure relief body (15).

10. Housing according to claim 8, **characterised in that** the housing part (12), measured at the peripheral face (23) of the pressure relief body (15), has a thickness (D) which is greater than the wall thickness (W) of the housing part (12), measured at a distance from the pressure relief opening (14).

## Revendications

1. Boîtier antidéflagrant (10),
comprenant au moins deux parties de boîtier (12, 13) qui, à l'état assemblé, délimitent un espace intérieur (11) dans lequel peuvent être logés des composants électriques susceptibles de constituer des sources d'inflammation,
dans lequel au moins une des parties de boîtier (12, 13) est une pièce coulée qui présente une ouverture de compensation de pression (14), comprenant au moins un corps de décharge de pression (15) qui présente deux côtés plats (16, 17), tournés dans des sens opposés, et est relié à la pièce coulée,
**caractérisé en ce que**
la pièce coulée est réalisée de manière à s'engager sur le corps de décharge de pression (15) sur ses deux côtés plats (16, 17).

2. Boîtier selon la revendication 1, **caractérisé en ce que** les matériaux pour la partie de boîtier (12) et le corps de décharge de pression (15) sont choisis tes que la température de fusion du matériau de la partie de boîtier (12) soit plus faible que la température de fusion du corps de décharge de pression (15), le matériau liquide de la partie de boîtier (12) ayant une tendance au mouillage faible ou nulle par rapport à la surface du corps de décharge de pression (15).

3. Boîtier selon l'une des revendications précédentes, **caractérisé en ce que** la partie de boîtier (12) est une pièce coulée en métal, de préférence une pièce coulée en aluminium.

4. Boîtier selon l'une des revendications précédentes, **caractérisé en ce que** les deux parties de boîtier (12, 13) sont réalisées de manière à se rejoindre au niveau d'une surface de séparation (18) qui est orientée parallèlement aux côtés plats (16, 17) du corps de décharge de pression (15).

5. Boîtier selon l'une des revendications précédentes, **caractérisé en ce que** le corps de décharge de pression (15) est un corps fritté à treillis métallique qui est constitué de plusieurs couches de toile métallique reliées entre elles par frittage.

6. Boîtier selon l'une des revendications précédentes, **caractérisé en ce que** les côtés plats (16, 17) du corps de décharge de pression (15) sont réalisés sous une forme plane au moins par portions ou en totali té.

7. Boîtier selon l'une des revendications précédentes, **caractérisé en ce que** le corps de décharge de pression (15) et l'ouverture de décharge de pression (14) présentent respectivement un contour rectangulaire, le contour du corps de décharge de pression (15) étant plus grand que le contour de l'ouverture de décharge de pression (14).

8. Boîtier selon l'une des revendications précédentes, **caractérisé en ce que** le corps de décharge de pression (15) présente une surface périphérique (23) qui s'étend entre les côtés plats (16, 17) et qui est réalisée comme surface de coupe lisse.

9. Boîtier selon la revendication 8, **caractérisé en ce que** la partie de boîtier (12), mesurée au niveau de la surface périphérique (23) du corps de décharge de pression (15), présente une épaisseur (D) qui est supérieure à l'épaisseur (D3) du corps de décharge de pression (15).

10. Boîtier selon la revendication 8, **caractérisé en ce que** la partie de boîtier (12), mesurée au niveau de la surface périphérique (23) du corps de décharge de pression (15), présente une épaisseur (D) qui est supérieure à l'épaisseur de paroi (W) de la partie de boîtier (12), mesurée à distance de l'ouverture de décharge de pression (14).
